**Europäisches Patentamt**

**European Patent Office**

**Office européen des brevets**

(19)

(11) Veröffentlichungsnummer: **0 169 356**
**B1**

(12) # EUROPÄISCHE PATENTSCHRIFT

(45) Veröffentlichungstag der Patentschrift:
02.11.88

(51) Int. Cl.⁴: **H 01 L 23/04**

(21) Anmeldenummer: **85107061.5**

(22) Anmeldetag: **07.06.85**

(54) Wechsellastbeständiges, schaltbares Halbleiterbauelement.

(30) Priorität: **09.06.84 DE 3421672**

(43) Veröffentlichungstag der Anmeldung:
**29.01.86 Patentblatt 86/5**

(45) Bekanntmachung des Hinweises auf die Patenterteilung:
**02.11.88 Patentblatt 88/44**

(84) Benannte Vertragsstaaten:
**CH FR GB IT LI**

(56) Entgegenhaltungen:
**EP-A-0 124 705**
**DE-A-1 614 603**
**DE-A-1 807 631**
**DE-A-2 221 673**
**DE-A-2 828 044**
**US-A-3 800 192**

(73) Patentinhaber: **SEMIKRON Elektronik GmbH,
Sigmundstrasse 200, D-8500 Nürnberg 82 (DE)**

(72) Erfinder: **Schierz, Winfried, Heideweg 2, D-8548
Heideck (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1988

## Beschreibung

Die Erfindung betrifft ein wechsellastbeständiges, schaltbares Halbleiterbauelement, bei dem die vorbehandelte Randzone der Halbleitertablette zwischen zwei ringförmigen Isolierkörpern angeordnet und mit einer oberflächenstabilisierenden Substanz abgedeckt ist, und bei dem der Stromleiter für die Steuerelektrode der Halbleitertablette durch einen der Isolierkörper geführt ist.

Halbleiterbauelemente hoher Strombelastbarkeit sind beim Einsatz unter wechselnder Belastung infolge des damit übereinstimmenden Wechsels der Betriebstemperatur insbesondere an den Verbindungsflächen aneinandergrenzender Materialien mit unterschiedlicher Wärmedehnung einer extremen Beanspruchung durch Schub- und Scherkräfte unterworfen. Einer solchen sogenannten Wechsebelastung halten Weichlotkontakte, wie sie zwischen dem Halbleitermaterial und angrenzenden Kontaktstücken bei Halbleiterbauelementen kleiner Leistung und für konstante Belastung verwendet werden, wegen der durch die extreme Beanspruchung entstehenden Versprödung der Kontaktschichten, der sogenannten Kontaktermüdung, nicht stand. Auch Maßnahmen zur Verbesserung solcher Lote brachten nicht in allen Fällen die gewünschte Wechsellastbeständigkeit von Lötkontakten.

Es ist bekannt, bei Halbleitergleichrichterelementen für derartige extreme Belastung Hartlotverbindungen zu verwenden. Der hohe Verfahrensaufwand und die häufig festgestellte Beeinträchtigung der Eigenschaften des Halbleitermaterials durch die hohen Verfahrenstemperaturen sind besondere Nachteile solcher Anordnungen.

Eine Lösung des Problems wurde mit der sogenannten Druckkontaktierung gefunden. Die Vorteile dieser Technik gegenüber der Lötkontaktierung bestehen darin, daß keine Kontaktermüdung eintritt, daß unter bestimmten Voraussetzungen mechanische Spannungen durch Gleiten aneinandergrenzender Materialien ausgeglichen werden, daß die Kontaktschichten zerstörungsfrei überprüft werden können, und daß der Verfahrensaufwand erheblich geringer ist.

Vergleichsweise zeigen Lötkontakte den Vorteil des niedrigeren thermischen Widerstandes und damit des besseren thermischen und auch elektrischen Betriebsverhaltens sowie einer höheren Stoßstrombelastbarkeit. Gerade diese Eigenschaften haben für den Betrieb von Halbleiterbauelementen mit wechselnder Belastung erhebliche Bedeutung.

Nun werden Halbleiterbauelemente außer in der Form von diskreten Einzelelementen auch in Halbleiterbaueinheiten in Kompaktbauweise, mit wenigstens zwei elektrisch geschalteten Elementen, d.h. in sogenannten Leistungsmodulen, bei Wechselbelastung eingesetzt. Ein Vorteil dieser Leistungsmodule ist der kostengünstige Aufbau mit einfacher elektrischer Kontaktierung der Bauteile. Erwünscht ist aus betriebswirtschaftlichen Gründen die Austauschbarkeit von Halbleiterbauelementen und deren Kontaktbauteilen in allen Schritten des Zusammenbaus. Dies zwingt zur Druckkontaktierung der Bauelemente.

Es sind Leistungsmodule bekannt, bei denen die Halbleiterbauelemente wohl druckkontaktiert, jedoch einschließlich eines Abschnitts der anschließenden Kontaktbauteile in Gießharz eingebettet sind. Dadurch sind jedoch die Vorteile der Druckkontaktierung unwirksam.

Bei anderen Modulbauformen sind die Halbleiterbauelemente durch Stapeln von Kontakt- und Hüllkörpern mit der Halbleitertablette sowie Verwendung von Dichtungsmitteln gebildet. Diese Anordnungen zeigen nicht in allen Fällen die gewünschte Langzeitstabilität.

Schließlich sind Leistungsmodule bekannt, welche diskrete scheibenförmige Halbleiterbauelemente mit einem erheblich kostenintensiven Aufbau aufweisen.

Den bekannten Halbleitervorrichtungen und -Baueinheiten ist gemeinsam, daß deren Halbleiterbauelemente oder die Teile derselben aufgrund ihrer spezifischen Ausgestaltung für die jeweilige Bauform nur in dieser anwendbar sind. Die beschränkten Einsatzmöglichkeiten solcher Halbleiterbauelemente machen auch eine aufwendige Lagerhaltung von Bauteilen erforderlich.

Der Erfindung liegt demgemäß die Aufgabe zugrunde, ein Halbleiterbauelement hoher Strombelastbarkeit für Wechselbelastung zu schaffen, das bei druckkontaktiertem Aufbau einen gegenüber bekannten Bauformen niedrigeren Wärmewiderstand, eine Ausgestaltung zur universellen Verwendung in unterschiedlichen Anordnungen und die gewünschte, behandlungsunabhängige Langzeitstabilität aufweist.

Untersuchungen haben überraschend ergeben, daß bei einem Halbleiterbauelement in druckkontaktierter Anordnung duktile Weichlotverbindungen der Hableitertablette auch einer Wechselbelastung standhalten.

Die Lösung der Aufgabe besteht demzufolge bei einem Halbleiterbauelement der eingangs erwähnten Art in den Merkmalen des Anspruchs 1. Vorteilhafte Ausgestaltungen der Erfindung sind in den Ansprüchen 2 bis 20 angegeben.

Bei einer Anordnung nach der Erfindung sind vorteilhaft sämtliche Kenngrößen in einfachster Weise meßbar. Sie stellt ein lagerfähiges, besonders kostengünstiges Zwischenprodukt dar, das in Vorrichtungen für ein oder mehrere Halbleiterbauelemente überraschend einfach elektrisch und räumlich wählbar eingebaut werden kann.

Aus der DE-PS-2 704 914 ist ein Halbleiterbauelement bekannt, dessen Halbleitertablette anodenseitig durch Löten oder Legieren und kathodenseitig durch Druck jeweils mit einer Kontaktronde aus Molybdän kontaktiert ist. Hinweise auf duktile Weichlotverbindungen sowie auf Maßnahmen für eine Struktur zum universellen Einsatz weist der bekannte Stand der Technik nicht auf.

Weiter ist in der DE-PS-3 009 511 ein Aufbau beschrieben, bei dem die Halbleitertablette anodenseitig mit einer Wolframronde legiert und kathodenseitig mit einer Molybdänronde druckkontaktiert ist und die Kontaktronden durch Löten mit Anschlußleitern aus Kupfer verbunden sind.

Schließlich ist ein elektrisch prüfbarer, besonders wirtschaftlicher, langzeitlagerfähiger und eine einfache Montage begünstigender Aufbau in EP-A-0 124 705 vorgeschlagen worden (Veröffentlichungsdatum 14. November 1984). Dieser ist in beliebiger Weise in herkömmlichen Scheibenzellen und in Baueinheiten mit zwei oder mehr Bauelementen beliebig einsetzbar. Dabei ist aus einer Halbleitertablette und aus einem diese ringförmig umfassenden Isolierkörper ein Halbleiterelement gebildet. Der Isolierkörper weist an seiner Innenmantelfläche eine der Randzone der Halbleitertablette angepaßte Vertiefung auf. Er ist zusätzlich an diese Vertiefung anschließend mit geeigneten Ausbildungen zur konzentrischen Anordnung von Kontaktbauteilen mit der Halbleitertablette versehen. Diese soll dann an ihrer Randzone in der Vertiefung eingeschlossen und gehalten sein. Mit einer solchen Anordnung ist jedoch die vorliegend gestellte Aufgabe nicht lösbar.

Anhand der in den Figuren 1 bis 4 dargestellten Ausführungsbeispiele wird der Gegenstand der Erfindung erläutert.

Figur 1 zeigt einen Querschnitt längs einer Mittelebene durch den Aufbau des Halbleiterbauelements.

In Figur 2 ist schematisch ein aus Halbleitertablette und beidseitig je ein Kontaktstück gebildeter Stapel dargestellt.

Figur 3 zeigt ebenfalls im Querschnitt eine andere Ausgestaltung der Isolierkörper, und in Figur 4 ist eine weitere Ausführungsform der Isolierkörper im Zusammenbau mit Halbleitertablette und Kontaktbauteilen, ebenfalls im Querschnitt, dargestellt.

Für gleiche Teile sind in allen Figuren gleiche Bezeichnungen gewählt.

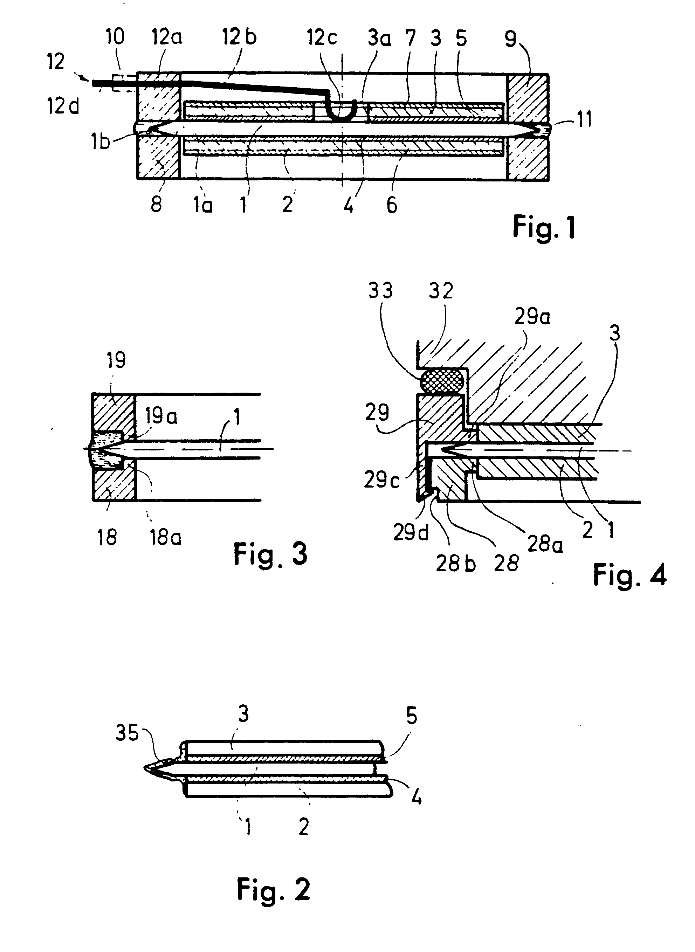

Bei einer Ausführung der Erfindung nach Figur 1 ist eine Halbleitertablette 1 anodenseitig über eine Lotkontaktschicht 4 und kathodenseitig über eine entsprechende Lotkontaktschicht 5 jeweils mit einem Kontaktstock 2 bzw. 3 fest verbunden. Die Halbleitertablette 1 weist eine Thyristorstruktur auf, und die nicht dargestellte Steuerelektrode ist im zentralen Bereich der Kathodenseite angeordnet. Dafür ist das entsprechende Kontaktstück 3 mit einer zentralen Aussparung 3a zum Anbringen des Steuerstromleiters 12 versehen.

Die Kontaktstücke haben vorzugsweise gleiche Abmessungen, um Verwölbungen durch Bi-Metalleffekte bei Erwärmungen zu vermeiden und bestehen aus einem Metall mit einem demjenigen des Halbleitermaterials entsprechenden, thermischen Ausdehnungskoeffizienten, z. B. aus Molybdän. Sie sind ferner an ihren Mantelflächen blank, damit beim Löten keine Lotbrücken entstehen. Die Lotkontaktflächen können eine nicht dargestellte lötfähige Metallisierung, z. B. aus Silber, aufweisen.

Erfindungsgemäß bestehen die Lotkontaktschichten 4, 5 bei einem solchen als Sandwich bezeichneten Aufbau aus Weichlotmetallen mit besonderer Warmfestigkeit, vorzugsweise aus Bleiloten mit 2,5 % Silber, Rest Blei, 2,5 % Silber, 1,5 % Indium, Rest Blei, 2,5 % Silber, 2,5 % Zinn, Rest Blei, 1,5 % Silber, 1,5 % Zinn, Rest Blei. Auch ein Zinn-Silber-Lot mit eutektischer Zusammensetzung ist geeignet.

Auf der von der Halbleitertablette abgewandten Seite sind die Kontaktstücke 2, 3 mit einem zur Kontaktierung mittels Druck geeigneten, metallischen Überzug 6, 7, z. B. aus Rhodium, Palladium oder Nickel versehen.

Diese beidseitige Weichlotverbindung der Halbleitertablette in Kombination mit einer Ausbildung zur Druckkontaktierung des Sandwich erfüllt in wirtschaftlich besonders vorteilhafter Weise die Forderungen nach einem wechsellastbeständigen Aufbau mit verbessertem thermischen Betriebsverhalten.

Die Kontaktstücke 2, 3 können auch durch Legieren an der Halbleitertablette befestigt sein.

Der aus Halbleitertablette 1 und Kontaktstücken 2, 3 gebildete Stapel 1 ist, insbesondere zum Schutz der Halbleiteroberfläche, an den freibleibenden Flächenabschnitten der drei Bauteile, d.h. an der Randzone der Halbleitertablette und an den Mantelflächen der Kontaktstücke, mit einer passivierenden und stabilisierenden Abdeckung 35 versehen, wie dies in Figur 2 dargestellt ist. Diese Abdeckung kann aus einem Glas, aus einem Oberflächenschutzlack oder aus einer organischen Verbindung, vorzugsweise einem Polyimid, bestehen.

Dieser meßbare und auch weiter verarbeitbare Stapel 1 ist zur Erzielung eines lagerfähigen, beliebig verarbeitbaren und universell verwendbaren Zwischenprodukts an seinem Umfang mit der vorbehandelten Randzone 1b der Halbleitertablette 1 in einem zwischen zwei koaxial aneinandergereihten, ringförmigen Isolierkörpern gebildeten Zwischenraum angeordnet. Dieser ist dadurch erreicht, daß je ein im wesentlichen zylinderförmiger Isolierkörper 8 bzw. 9 mit wenigstens einem Teil seiner Stirnfläche unmittelbar anschließend an das entsprechende Kontaktstück auf den Randbereich der Halbleitertablette 1 aufgesetzt

ist. Die Tablettenrandzone 1b ragt dann in den Zwischenraum hinein, der mit einer zusätzlichen passivierenden und stabilisierenden Substanz 11 gefüllt ist. Die oberflächengeschützte Tablettenrandzone 1b taucht ganz in die Substanz 11 ein, die zusätzlich Klebeeigenschaft gegenüber dem Material der schützenden Abdeckung 35 und der Isolierkörper 8, 9 aufweist und zu deren fester gegenseitiger Verbindung dient. Durch den Stapel 1 und die Isolierkörper 8, 9 ist die Halbleitertablette an beiden Seiten und im Verlauf ihrer Randzone dicht eingeschlossen und auch mechanisch geschützt angeordnet. Als oberflächenstabilisierende Substanz 11 eignen sich Silicon-Kautschuke mit Klebeeigenschaft, z. B. ein unter dem Warenzeichen Hipec erhältlicher Kautschuk von der Firma Dow Corning.

Die Form der Tablettenrandzone 1b kann beliebig sein. Sie ist in der Zeichnung jeweils mit einer Kontur mit doppelt negativem Winkel dargestellt.

Einer der ringförmigen Isolierkörper 8 dient als Halter für den Steuerstromleiter 12. Dieser besteht aus einem Federmaterial und ist als Blattfeder ausgebildet. Der erste Abschnitt 12a ist für einen dichten Einschluß im Isolierkörper abgeflacht und mit stark aufgerauhter Oberfläche ausgebildet. Der angrenzende Abschnitt 12b ist gegen das Kontaktstück 3 geneigt angeordnet, und das bogenförmige Ende 12c liegt unter Druck auf der Steuerelektrode auf. Der durch Form und Material erzielte Kontaktdruck hat eine Zugbeanspruchung der Klebeverbindung der Isolierkörper 8, 9 zur Folge, die bei der Materialauswahl der Substanz 11 zu berücksichtigen ist.

Zur Verlängerung der Kriechstrecke kann der Isolierkörper 8 an seiner Außenmantelfläche mit einer Erhebung 10 zur Aufnahme und Umhüllung eines größeren Abschnitts 12a des Steuerstromleiters 12 versehen sein, der durch Umspritzen oder Umpressen im Isolierkörper 8 fest und dicht angebracht ist.

Zur gezielten Anordnung des jeweiligen Isolierkörpers (18, 19) kann ferner auf jeder Seite der Halbleitertablette 1 zwischen Hauptstromfläche und abgeschrägter Randzone bzw. Mantelfläche ein freier Randstreifen 1a vorgesehen sein. Dies ist auch aus Figur 1 zu erkennen. Für eine solche gezielte Anbringung der Isolierkörper kann nach einer Weiterbildung der Erfindung jeder der zylinderförmigen Isolierkörper 18, 19 gemäß der Darstellung in Figur 3 an seiner entsprechenden Stirnfläche einen Ansatz 18a, 19a aufweisen, mit welchem sie auf dem jeweiligen Randstreifen 1a der Halbleitertablette aufgesetzt sind und eine klammerförmige Halterung für die Halbleitertablette bilden. Dadurch ist außerdem ein erweiterter Zwischenraum zur optimalen Einbettung der Tablettenrandzone in die Substanz 11 erzielbar.

Eine andere vorteilhafte Weiterbildung der Erfindung ist in Figur 4 gezeigt. Die Isolierkörper 28, 29 weisen an ihrer an die innere Stirnfläche angrenzenden Innenmantelfläche jeweils eine in sich geschlossene, schulterförmige Verstärkung 28a, 29a auf. Deren Höhe ist vorzugsweise niedriger als die Bauhöhe der Kontaktstücke 2, 3, und sie erleichtert das Anordnen eines weiteren, zur Druckkontaktierung des Sandwich vorgesehenen Bauteils 32, welches bei druckkontaktierter Vorrichtung über einen Dichtring 33 einen dichten Einschluß des Sandwich gewährleistet.

Die Isolierkörper sind zur gegenseitigen Befestigung durch Einrasten entsprechend ausgebildet. Dazu weist der obere Isolierkörper 29 in Verlängerung seiner Außenmantelfläche einen hülsenförmigen Überwurf 29c auf, und das sägezahnförmige Ende 29d des Überwurfs ist in eine angepaßte Ausnehmung 28b des unteren Isolierkörpers 28 eingerastet. Beide Isolierkörper können so bemessen sein, daß die Elastizität des Materials genutzt werden kann. Andernfalls ist die Verlängerung der Außenmantelfläche des einen Isolierkörpers nicht in Form einer Hülse sondern lediglich in Form einer größeren Anzahl stegförmiger Fortsätze ausgebildet, welche beim Aufsetzen des oberen Isolierkörpers auf den unteren spreizen und eine längere Strecke des Endes 29d zum Eingriff in die Ausnehmung 28b erlauben.

Die Bauhöhe der Isolierkörper ist durch die gewünschte Anwendung sowohl in scheibenförmigen Halbleiteranordnungen mit genormter Höhe als auch in Baueinheiten mit mehreren Bauelementen und mit unterschiedlichen Gehäusemaßen bestimmt. Als Material für die Isolierkörper sind besonders kriechstromfeste Spritz- oder Preßmassen, vorzugsweise mit Glasfaserfüllung, geeignet, wie sie z. B. unter dem Warenzeichen Polysulfon oder Ryton auf dem Markt erhältlich sind.

Zur Herstellung des Gegenstandes der Erfindung wird in einem ersten Verfahrensabschnitt mit Hilfe von Justier- und Maskierschritten durch Löten der Kontaktstocke 2, 3 an die Halbleitertablette 1 mittels Bleilot der Stapel 1 gebildet. Bei entsprechender Bemessung der Bauteile ist damit gleichzeitig der vorgesehene Randstreifen 1a der Halbleitertablette 1 zum gezielten Aufsetzen der Isolierkörper 8, 9 gegeben. Anschließend wird die freie Halbleiteroberfläche vorteilhaft mittels Siebdruck mit der schützenden, passivierende und stabilisierende Wirkung auf das Halbleitermaterial entfaltenden Abdeckung 35 versehen. Eine Abdeckung aus einer organischen Verbindung, d.h. aus einem Polyimid, ist besonders günstig aufzubringen. Darauf wird im Bereich der Halbleiterrandzone 1b ein Siliconharz 11 in solcher Menge aufgebracht, daß bei dem nachfolgenden Aufsetzen der Isolierkörper 8, 9 der durch diese und die Halbleitertablette 1 gebildete Zwischenraum mit der Substanz 11 gefüllt ist und die Randzone 1b völlig in diese eintaucht. Damit werden aber auch die Stirnseiten der Isolierkörper mit der Substanz 11 beschichtet. Bei einer entsprechenden Erwärmung polymerisiert das Siliconharz 11 und bildet dadurch eine feste gegenseitige Verbindung von Isolierkörpern und Halbleitertablette. Gleichzeitig mit der Anordnung der Isolierkörper wird auch das gehäuseinnere Ende des Steuerstromleiters auf die Halbleitertablette aufgesetzt.

**Patentansprüche**

1. Wechsellastbeständiges, schaltbares Halbleiterbauelement, bei dem die vorbehandelte Randzone der Halbleitertablette zwischen zwei ringförmigen Isolierkörpern angeordnet und mit einer oberflächenstabilisierenden Substanz abgedeckt ist, und bei dem der Stromleiter für die Steuerelektrode der Halbleitertablette durch einen der Isolierkörper geführt ist, wobei
a) kleinen aus der Halbleitertablette (1) und je einem an ihren beiden Hauptstromflächen befestigten Kontaktstück (2, 3) gebildeten Stapel (I) aufweist,
b) die freie Kontaktfläche der Kontaktstücke (2, 3) jeweils mit einem zur Druckkontaktierung geeigneten, metallischen Überzug (6, 7) versehen ist,
c) die freibleibenden Flächenabschnitte des Stapels (I) mit einer schützenden Abdeckung (35) überzogen sind,
d) die zwischen den Isolierkörpern (8, 9) angeordnete Randzone (1b) in eine Substanz (11) eintaucht, die Klebewirkung auf die angrenzenden Materialien aufweist, und dadurch auch mit den Isolierkörpern verbunden ist,
e) aus den angrenzend an die Kontaktstücke (2, 3) an der Halbleitertablette (1) angebrachten Isolierkörpern (8, 9) und des Stapel (I) eine dichte Umhüllung der Halbleitertablette gebildet ist, und
f) der durch den einen Isolierkörper (9) verlaufende Abschnitt (12a) des Steuerstromleiters (12) fest und dicht eingeschlossen ist.

2. Halbleiterbauelement nach Anspruch 1, dadurch gekennzeichnet, daß die Kontaktstücke (2, 3) gleiche Abmessungen aufweisen und aus einem Material mit einem demjenigen des Halbleitermaterials angepaßten thermischen Ausdehnungskoeffizienten bestehen.

3. Halbleiterbauelement nach Anspruch 1 oder 2, dadurch gekennzeichnet, daß die Kontaktstücke (2, 3) durch Löten an der Halbleitertablette (1) befestigt sind.

4. Halbleiterbauelement nach Anspruch 3, dadurch gekennzeichnet, daß die Kontaktstücke (2, 3) jeweils an ihrer Lötkontaktfläche mit einer das Löten begünstigenden Metallisierung, z. B. aus Silber, versehen sind.

5. Halbleiterbauelement nach Anspruch 1, dadurch gekennzeichnet, daß die Kontaktstücke (2, 3) durch Legieren an der Halbleitertablette (1) befestigt sind.

6. Halbleiterbauelement nach Anspruch 1, dadurch gekennzeichnet, daß die Kontaktstücke (2, 3) jeweils an der zur Druckkontaktierung vorgesehenen Fläche einen Edelmetallüberzug (6, 7) aufweisen.

7. Halbleiterbauelement nach Anspruch 1, dadurch gekennzeichnet, daß die Kontaktstücke (2, 3) jeweils an der zur Druckkontaktierung vorgesehenen Fläche einen metallischen Überzug aus Nickel aufweisen.

8. Halbleiterbauelement nach Anspruch 1, dadurch gekennzeichnet, daß die Halbleitertablette (1) auf jeder Seite zwischen Hauptstromfläche und der der Mantelfläche entsprechenden Randzone (1b) einen freien Randstreifen (1a) zur gezielten Anordnung des jeweiligen Isolierkörpers (18, 19) aufweist.

9. Halbleiterbauelement nach Anspruch 1, dadurch gekennzeichnet, daß als oberflächenstabilisierende Substanz (11) mit Klebewirkung eine Kautschuk-Klebemasse vorgesehen ist.

10. Halbleiterbauelement nach Anspruch 1, dadurch gekennzeichnet, daß die ringförmigen Isolierkörper (18, 19) im wesentlichen zylinderförmig ausgebildet sind und jeweils an ihrer der Halbleitertablette (1) zugewandten Stirnfläche einen Ansatz (18a, 19a) aufweisen, mit dem sie eine klammerförmige Halterung für die Halbleitertablette bilden.

11. Halbleiterbauelement nach Anspruch 1, dadurch gekennzeichnet, daß die ringförmigen Isolierkörper (28, 29) an ihrer Innenmantelfläche eine schulterförmige Verdickung (28a, 29a) zur justierten Aufnahme von weiteren Kontaktbauteilen (32) aufweisen.

12. Halbleiterbauelement nach Anspruch 1, dadurch gekennzeichnet, daß einer der ringförmigen Isolierkörper (29) in Verlängerung seiner Außenmantelfläche einen hülsenförmigen Fortsatz (29c) mit hakenförmigem Ende (29d) aufweist, und daß durch Einrasten desselben in eine entsprechende Aussparung (28b) der Außenmantelfläche des anderen Isolierkörpers (28) eine feste Verbindung der Isolierkörper gegeben ist.

13. Halbleiterbauelement nach Anspruch 1, dadurch gekennzeichnet, daß der Steuerstromleiter (12) aus einem Federmaterial besteht, als Blattfeder (12b, 12c) ausgebildet und in einer Aussparung (3a) des entsprechenden Kontaktstücks (3) so angeordnet ist, daß die Steuerelektrode der Halbleitertablette (1) mittels Federdruck kontaktiert ist.

14. Halbleiterbauelement nach Anspruch 1, dadurch gekennzeichnet, daß der durch den einen Isolierkörper (9) verlaufende Abschnitt (12a) des Steuerstromleiters (12) abgeflacht, verbreitert und aufgerauht ausgebildet ist.

15. Halbleiterbauelement nach Anspruch 3, dadurch gekennzeichnet, daß als Lotmetall zur Befestigung der Kontaktstücke (2, 3) Bleilote mit 2,5 bis 5 Gewichtsprozent Zinn, 2,5 bis 5 Gewichtsprozent Silber, Rest Blei vorgesehen sind.

16. Halbleiterbauelement nach Anspruch 3, dadurch gekennzeichnet, daß als Lotmetall ein eutektisches Zinn-Silber-Lot vorgesehen ist.

17. Halbleiterbauelement nach Anspruch 1, dadurch gekennzeichnet, daß als schützende Abdeckung der freiliegenden Flächenabschnitte des Stapels (1) bekannte Oberflächenschutzabdeckungen für Halbleiteroberflächen wie Glas, Polyimid oder Silikonlack vorgesehen sind.

18. Halbleiterbauelement nach Anspruch 1, dadurch gekennzeichnet, daß die ringförmigen Isolierkörper (8, 9; 18, 19; 28, 29) aus einem Kunststoff, z. B. aus Polysulfon, bestehen.

19. Halbleiterbauelement nach Anspruch 1, dadurch gekennzeichnet, daß die Halbleitertablette eine Thyristor-Struktur aufweist.

20. Halbleiterbauelement nach Anspruch 1, dadurch gekennzeichnet, daß die Halbleitertablette eine Transistor-Struktur aufweist.

## Claims

1. Switchable semiconductor device which will withstand load variation, wherein the pretreated edge zone of the semiconductor wafer is located between two ring-shaped insulating bodies and is covered with a surface-stabilizing substance, wherein the current conductor for the control electrode of the semiconductor wafer is led through one of the insulating bodies, and wherein

a) a stack (I) is assembled from the semiconductor wafer (1) and two contact pieces (2, 3) which are fastened to the two principal current surfaces of the wafer, in a sandwich arrangement,

b) the exposed contact surface of each contact piece (2, 3) is provided with a metal coating (6, 7) which is suitable for maintaining electrical contact by pressure,

c) a protective covering (35) is applied to those portions of the surface of the stack (I) which remain exposed,

d) the edge zone (1b) is located between the insulating bodies (8, 9), dipping into a substance (11) which acts on the adjoining materials as an adhesive and thus bonds to the insulating bodies as well,

e) leaktight encapsulation of the semiconductor wafer (1) is formed by the insulating bodies (8, 9) and the stack (I), the insulating bodies (8, 9) being affixed to the semiconductor wafer immediately adjacent to the contact pieces (2, 3), and

f) the section (12a) of the control current conductor (12) running through one of the insulating bodies, namely the body (9), is permanently fixed therein, in a manner such that leaktight sealing is achieved.

2. Semiconductor device according to Claim 1, characterized in that the contact pieces (2, 3) have identical dimensions, and are composed of a material with a thermal expansion coefficient matched to that of the semiconducting material.

3. Semiconductor device according to Claim 1 or 2, characterized in that the contact pieces (2, 3) are fastened to the semiconductor wafer (1) by soldering.

4. Semiconductor device according to Claim 3, characterized in that a metallized finish which aids soldering is applied to that surface of each contact piece (2, 3) which is to be solder-bonded, silver metallization being an example of a suitable finish.

5. Semiconductor device according to Claim 1, characterized in that the contact pieces (2, 3) are fastened to the semiconductor wafer (1) by alloying.

6. Semiconductor device according to Claim 1, characterized in that a noble metal coating (6, 7) is applied to those surfaces of the contact pieces (2, 3) which are destined for pressure-bonding.

7. Semiconductor device according to Claim 1, characterized in that a nickel coating is applied to those surfaces of the contact pieces (2, 3) which are destined for pressure-bonding.

8. Semiconductor device according to Claim 1, characterized in that, on each side, the semiconductor wafer (1) exhibits an exposed edge strip (1a), between the principal current surface and the edge zone (1b) that corresponds to the cylindrical surface, the purpose of these edge strips (1a) being to ensure accurate location of the insulating bodies (18, 19).

9. Semiconductor device according to Claim 1, characterized in that a rubber-based adhesive compounds is used as the surface-stabilizing substance (11) which acts as an adhesive.

10. Semiconductor device according to Claim 1, characterized in that the ring-shaped insulating bodies (18, 19) are of substantially cylindrical configuration, and each has a shoulder (18a, 19a) on its end face that faces the semiconductor wafer (1), these shoulders being the means whereby the insulating bodies form a clamp-shaped arrangement for holding the semiconductor wafer.

11. Semiconductor device according to Claim 1, characterized in that, on their inner cylindrical surface, the ring-shaped insulating bodies (28, 29) have a shoulder-shaped enlargement (28a, 29a) for facilitating the adjusted mounting of further contact components (32).

12. Semiconductor device according to Claim 1, characterized in that one of the ring-shaped insulating bodies (29) exhibits a sleeve-shaped prolongation (29c), forming an extension of its outer cylindrical surface and having a hook-shaped end (29d), and in that the insulating bodies are securely fastened together as a result of the snapping of this end (29d) into a matching recess (28b) in the outer cylindrical surface of the other insulating body (28).

13. Semiconductor device according to Claim 1, characterized in that the control current conductor (12) is composed of a spring material, is shaped as a leaf spring (12b, 12c), and is mounted in an aperture (3a) in the corresponding contact piece (3), in a manner such that spring pressure maintains it in electrical contact with the semiconductor wafer (1).

14. Semiconductor device according to Claim 1, characterized in that the section (12a) of the control current conductor (12) running through one of the insulating bodies, namely the body (9), is formed with a flattened, widened and roughened surface.

15. Semiconductor device according to Claim 3, characterized in that lead-based solders are used for fastening the contact pieces (2, 3), these solders containing 2,5 to 5 weight percent of tin and 2,5 to 5 weight percent of silver, the balance being lead.

16. Semiconductor device according to Claim 3, characterized in that an eutectic tin-silver solder is used.

17. Semiconductor device according to Claim 1, characterized in that known protective coverings for semiconductor surfaces are used as the protective covering for the exposed portions of the surface of the stack (1), suitable coverings including certain glasses, polyimides and silicone lacquers.

18. Semiconductor device according to Claim 1, characterized in that the ring-shaped insulating bodies (8, 9; 18, 19; 28, 29) are composed of a plastic, such as a polysulphone.

19. Semiconductor device according to Claim 1, characterized in that the semiconductor wafer has a thyristor structure.

20. Semiconductor device according to Claim 1, characterized in that the semiconductor wafer has a transistor structure.


**Revendications**

1. Dispositif semi-conducteur à commutation résistant aux changements de charges, dont la zone périphérique prétraitée de la plaquette semi-conductrice est implantée entre deux corps isolants annulaires et recouverte par une matière stabilisatrice de surface, et dont le conducteur de courant de l'électrode de commande de la plaquette semi-conductrice traverse un corps isolant, caractérisé en ce que

a) le dispositif semi-conducteur présente une pile (I) formée par la plaquette semi-conductrice (1) et des éléments de contact (2, 3) fixés sur chaque côté des deux surfaces de courant principal,

b) la surface de contact libre des éléments de contact (2, 3) est munie d'un revêtement métallique (6, 7) adapté au contact par pression.

c) les surfaces de la pile (I) demeurant libres sont revêtues d'un recouvrement de protection (35).

d) la zone périphérique (1b) située entre les corps isolants (8, 9) est immergée dans une matière (11) présentant un effet d'adhérence sur les matériaux périphériques et est de ce fait également raccordée aux corps isolants.

e) un enrobage étanche de la tablette semi-conductrice est formée par les corps isolants (8, 9) et la pile (1) fixés sur la plaquette semi-conductrice (I) à proximité des éléments de contact (2, 3)

f) la section (12a) du conducteur de courant de commande (12) traversant un corps isolant (9) est entouré de manière fixe et étanche.

2. Dispositif semi-conducteur selon la revendication 1, caractérisé en ce que les éléments de contact (2, 3) présentent des dimensions identiques et sont constitués par un matériau possédant un coefficient d'allongement thermique adapté à celui du matériau de la plaquette semi-conductrice.

3. Dispositif semi-conducteur selon la revendication 1 ou 2, caractérisé en ce que les éléments de contact (2, 3) sont fixés sur la plaquette semi-conductrice (1) par soudage.

4. Dispositif semi-conducteur selon la revendication 3, caractérisé en ce que les éléments de contact (2, 3) sont chacun munis, sur leur surface de contact par soudure, d'une métallisation, par exemple en argent, favorisant la soudure.

5. Dispositif semi-conducteur selon la revendication 1, caractérisé en ce que les éléments de contact (2, 3) sont fixés sur la plaquette semi-conductrice (1) par alliage.

6. Dispositif semi-conducteur selon la revendication 1, caractérisé en ce que les éléments de contact (2, 3) présentent, sur chacune des surfaces prévues pour le contact par pression, un revêtement en métal noble (6, 7).

7. Dispositif semi-conducteur selon la revendication 1, caractérisé en ce que les éléments de contact (2, 3) présentent, sur chacune des surfaces prévues pour le contact par pression, un revêtement métallique en nickel

8. Dispositif semi-conducteur selon la revendication 1, caractérisé en ce que la plaquette semi-conductrice (1) présente sur chaque côté entre la surface de courant principal et la zone périphérique (1b) correspondant à celle de la gaine une bordure (1a) libre pour une mise en place adéquate de chaque corps isolant (18, 19).

9. Dispositif semi-conducteur selon la revendication 1, caractérisé en ce que la matière stabilisante de surface (11) avec effet d'adhérence prévue est une masse adhérente de caoutchouc.

10. Dispositif semi-conducteur selon la revendication 1, caractérisé en ce que les corps isolants annulaires (18, 19) sont principalement réalisés sous forme cylindrique et présentent, sur chacune de leurs faces avant orientée vers la plaquette semi-conductrice (1), un prolongement (18a, 19a) par lequel ils forment un support en forme de pince pour la plaquette semi-conductrice.

11. Dispositif semi-conducteur selon la revendication 1, caractérisé en ce que les corps isolants annulaires (28. 29) présentent, sur la surface intérieure de leur gaine une bosse (28a, 29a) en forme d'épaulement pour la réception ajustée d'éléments de contact supplémentaires (32).

12. Dispositif semi-conducteur selon la revendication 1, caractérisé en ce que l'un des corps isolants annulaires (29) possède, dans le prolongement de la surface de sa gaine extérieure, une collerette de prolongation (29c) à extrémité en forme de crochet (29d) et que l'encliquetage de ladite dans un évidement correspondant (28b) de la surface extérieure de la gaine de l'autre corps isolant (28) réalise une liaison solide des corps isolants

13. Dispositif semi-conducteur selon la revendication 1, caractérisé en ce que le conducteur de courant de commande (12) est constitué par un matériau de ressort réalisé en tant que ressort à lame (12b, 12c) et est implanté dans un évidement (3a) de l'élément de contact correspondant (3) de telle sorte que l'électrode de commande de la plaquette semi-conductrice (1) est activée par la pression de ressort.

14. Dispositif semi-conducteur selon la revendication 1, caractérisé en ce que la section (12a) du conducteur de courant de commande (12) traversant un corps isolant (9) est réalisée aplatie, élargie et rugueuse.

15. Dispositif semi-conducteur selon la revendication 3, caractérisé en ce que le métal prévu pour la fixation des éléments de contact (2, 3) est un fil de soudure avec de 2,5 à 5 % en poids d'étain, 2,5 à 5 % en poids d'argent, reste plomb.

16. Dispositif semi-conducteur selon la revendication 3, caractérisé en ce que le métal de soudure prévu est un fil de soudure eutectique étain-argent.

17. Dispositif semi-conducteur selon la revendication 1, caractérisé en ce que sont prévus, en tant que recouvrement protecteur des section de surfaces libres de la pile (1), des recouvrements de surfaces pour surfaces de semi-conducteurs connus comme le verre, le polyimide ou le vernis au silicone.

18. Dispositif semi-conducteur selon la revendication 1, caractérisé en ce que les corps isolants (8, 9; 18, 19; 28, 29) sont constituées par une matière plastique, par exemple par du polysulfane.

19. Dispositif semi-conducteur selon la revendication 3, caractérisé en ce que la plaquette semi-conductrice présente une structure de thyristor.

20. Dispositif semi-conducteur selon la revendication 1, caractérisé en ce que la plaquette semi-conductrice présente une structure de transistor.

0 169 356

Fig. 1

Fig. 3

Fig. 4

Fig. 2

1